# EUROPEAN PATENT APPLICATION

(11) **EP 3 340 474 A1**
(43) Date of publication of application: **27.06.2018**
(21) Application number: 16205911.7
(22) Date of filing: 21.12.2016
(51) Int. Cl.: H03M 3/00, H03M 1/66

(54) **SIGMA-DELTA CONVERTER**

(71) Applicant: Intel IP Corporation, Santa Clara, CA 95054 (US)
(72) Inventor: DI GIANDOMENICO, Antonio, 9524 Villach (AT); KAMPUS, Vahur, 9500 Villach (AT)
(74) Representative: Sticht, Andreas

(57) **Abstract**

Analog-to-digital converter devices and methods are provided, where feedback using a nonlinear digital-to-analog converter is used. In some implementations, such a nonlinear digital-to-analog converter feedback may be used to compensate extra loop delay while maintaining stability and/or not injecting any additional noise.

## Description

### TECHNICAL FIELD

The present application relates to sigma-delta converters and associated conversion methods.

### BACKGROUND

Sigma-delta analog-to-digital converters (ADCs), in particular continuous time sigma-delta ADCs, have been extensively used in wideband communication systems, as they offer comparatively low power consumption, require comparatively small chip area and are comparatively easy to incorporate from a system perspective, because they require almost no calibration or other pre-usage training algorithms to work. Furthermore, sigma-delta ADCs, at least in some implementations, may provide an inherent anti-aliasing function. Sigma-delta ADCs are sometimes also referred to as sigma-delta modulators.

Sigma-delta ADCs in many cases comprise of a sigma-delta loop including at least an integrator, a quantizer and a feedback digital-to-analog converter (DAC). The integrator may be an active integrator or a passive integrator.

In such sigma-delta ADCs, the feedback DAC and the analog signal it outputs ideally responds immediately to a clock edge clocking of the quantizer, but behavior of real circuit components like non-zero transistor switching time of transistors used in the quantizer and the digital-to-analog converter result in a finite delay between the quantizer and the digital-to-analog converter, which is referred to as excess loop delay (ELD).

Various approaches have been discussed for compensating this excess loop delay. One approach is to provide an additional feedback via an additional digital-to-analog converter the output of which is subtracted from the quantizer input, therefore creating a zero in a transfer function of the sigma-delta-converter at high frequencies.

However, small signal levels at an input of the sigma-delta ADC, may lead to very small signals at an input of the quantizer, so that the loop essentially works only in a single bit operation. In this condition, the gain of the quantizer increases, also increasing the gain of the whole loop of the sigma-delta analog-to-digital converter. This may lead to a loss of stability inside the loop, which may in a worse case even lead to oscillations.

A conventional way to solve this problem is to use an additional digital-to-analog converter, also referred to as a dithering digital-to-analog converter, which generates random noise and forces the signal at the input of the quantizer to toggle between more than two least significant bit (LSB) codes. In this case, the quantizer gain is restored to zero dB and stability of the loop is recovered. However, this extra digital-to-analog converter requires additional chip area and power, while at the same time increasing noise and reducing performance.

### BRIEF DESCRIPTION OF THE DRAWINGS

Fig. 1 is a block diagram of a sigma-delta analog-to-digital converter according to an embodiment.
Fig. 2 is a circuit diagram of a sigma-delta analog-to-digital converter according to an embodiment.
Fig. 3 is a circuit diagram of a sigma-delta analog-to-digital converter according to a further embodiment.
Fig. 4 is a flow chart illustrating a method according to an embodiment.

### DETAILED DESCRIPTION

In the following, various embodiments will be described in detail referring to the attached drawings. It should be noted that the embodiments shown in the drawings and described herein serve as illustrative examples only and are not to be construed as limiting in any way. For example, while some embodiments may be described as comprising a plurality of features or elements, in other embodiments some of these features or elements may be omitted and/or may be replaced by alternative features or elements. Furthermore, in addition to the features and elements explicitly described herein and shown in the drawings, further features or elements, for example features or elements used in conventional sigma-delta analog-to-digital converters, may be provided.

Features from different embodiments may be combined unless noted otherwise. Variations and modifications described with respect to one of the embodiments may also be applied to other embodiments unless noted otherwise.

Electrical connections shown herein or described in the drawings may be direct connections, i.e. connections without additional intervening elements, or indirect connections or couplings, i.e. connections or couplings comprising one or more additional intervening elements, as long as the general purpose and function of the connection or coupling, for example to provide a certain kind of signal or a certain kind of control, is essentially maintained.

In some embodiments, a nonlinear digital-to-analog converter may be used to provide additional feedback in a sigma-delta analog-to-digital converter. In some embodiments, with such an approach excess loop delay may be compensated while maintaining stability.

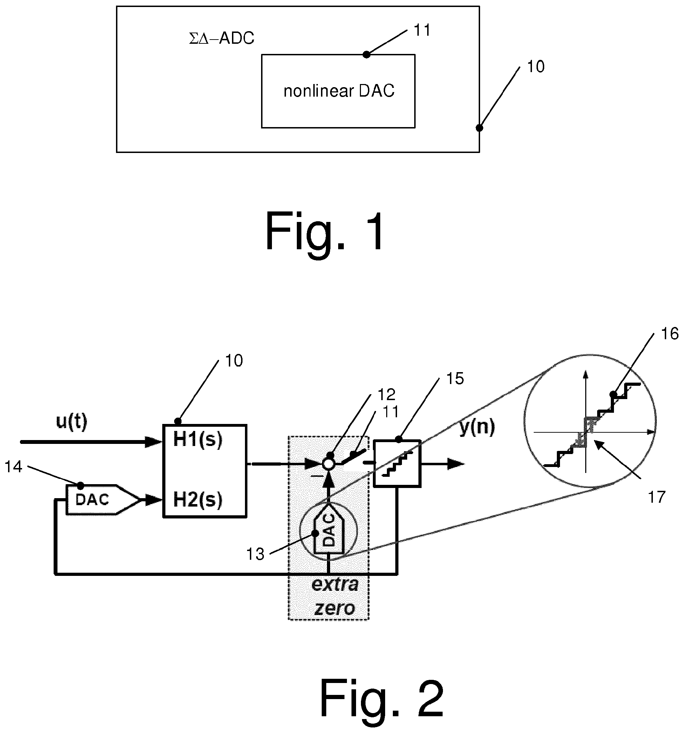

Turning now to the figures, Fig. 1 schematically shows a sigma-delta analog-to-digital converter (ΣΔ-ADC) 10 according to an embodiment. ΣΔ-ADC 10 comprises a nonlinear digital-to-analog converter (DAC) 11 in addition to the feedback path. Nonlinear DAC 11 may in particular have a larger output step size around zero than for input values further away from zero. By using a nonlinear digital DAC like DAC 11 with an additional feedback path, excess loop delay (ELD) may be compensated in some embodiments without introducing extra noise and/or stability problems.

Fig. 2 illustrates a circuit diagram of a ΣΔ-ADC according to an embodiment. The ΣΔ-ADC of Fig. 2 receives an analog input signal u(t) and outputs a series of corresponding digital values y(n). The ΣΔ-ADC of Fig. 2 is implemented as a continuous time ΣΔ-ADC.

The ΣΔ-ADC of Fig. 2 comprises an integrating loop filter 10 with transfer functions H1(s) for the input signal u(t) and H2(s) for a feedback signal received via a feedback DAC 14. Integrating loop filter 10 may comprise a single stage or a multistage integrator. Feedback DAC 14 may be implemented in any conventional manner.

An output of integrating loop filter 10 is coupled to a positive input of an adder 12. An output of adder 12 is provided to a quantizer 15, for example a flash analog-to-digital converter, which has a sampling switch 11 sampling with a sampling frequency fs corresponding to a sampling period Ts. Sampling switch 11 may be integrated in quantizer 15. Quantizer 15 outputs the output signal y(n) and furthermore provides the output signal as digital feedback signal to an input of DAC 14.

For an excess loop delay compensation, an additional nonlinear DAC 13 is provided to provide an additional feedback path. Nonlinear DAC 13 receives the digital feedback signal from quantizer 15 as an input. An output of nonlinear DAC 13 is coupled to a negative input of adder 12.

In nonlinear DAC 13, the output signal depends on an input signal value in a nonlinear manner. In particular, as indicated by an arrow 17 in an example aquantization curve 16 of DAC 13 which shows a magnitude of the output signal depending on the digital input signal, a first "step" in curve 16 is comparatively larger and a second step is comparatively smaller, before steps of equal height follow. This means that for small values of the input signal of about one least significant bit (LSB), comparatively larger outputs signals are output by DAC 13 than in a linear case. This in turn in some embodiments helps to avoid stability problems without increasing noise and/or needing an additional dithering digital-to-analog converter.

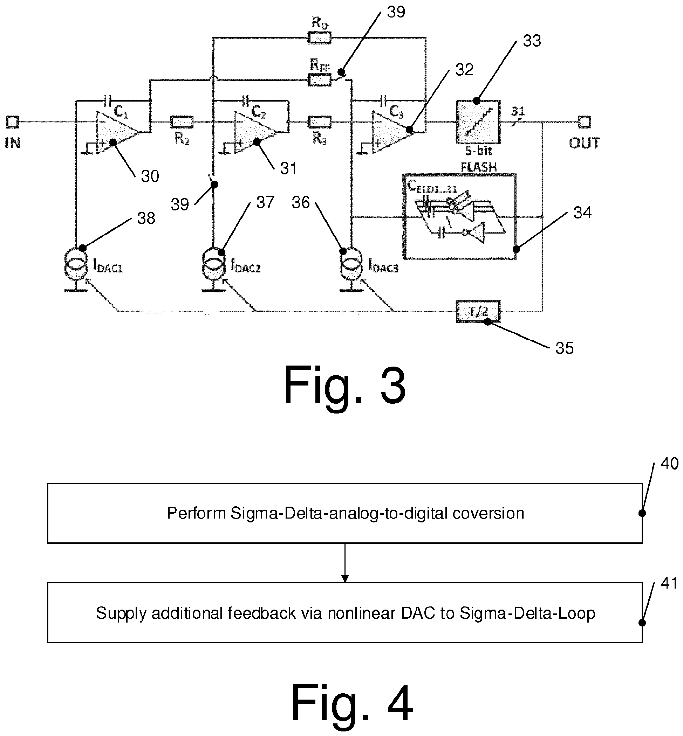

Fig. 3 is a circuit diagram illustrating a ΣΔ-ADC according to an embodiment. The ΣΔ-ADC of Fig. 3 comprises a three stage filter comprising integrators 30, 31, 32 with associated feedback capacitors C₁, C₂, C₃, and resistors R₂, R₃, R_{FF} and R_{D} as shown. An input signal IN is provided to a negative input of integrator 30. Integrator 31 receives an output of integrator 30 via resistor R₂ at its negative input, and integrator 32 receives an output of integrator 31 via resistor R₃ at its negative input. Positive inputs of integrators 30-32 are coupled to ground. An output of comparator 32 is provided to an input of an analog-to-digital converter 33, which in the example shown may be a 5 bit flash ADC outputting a 31 bit signal as output signal OUT. However, depending on the application other bit widths may be used. Switches 39 may be used for configuration purposes.

Feedback DACs are represented as current sources 36, 37, 38 controlled by the output signal of quantizer 33 via a delay element 35 delaying the signal by half a sampling period T/2.

Furthermore, the ΣΔ-ADC of Fig. 3 comprises an additional nonlinear DAC 34 which receives the output signal from quantizer 33 and provides an additional feedback signal as illustrated in Fig. 3. Nonlinear DAC 34 in the embodiment of Fig. 3 is implemented with a capacitive adder comprising of 2ⁿ elements, where n is the number of bits. Each element in the example shown with 31 bits has 31 capacitors, where the capacitors number 1 to 14 and number 16 to 31 may have a , constant capacitance value, for example about 5 Femtofarad (fF), and the "middle" capacitor number 15 is scaled with respect to this value by a factor α, which is greater than 1. This leads to a behavior of nonlinear DAC 31 similar to the one shown in curve 16 in Fig. 2, i.e. a nonlinear behavior with a greater output step around zero. Nonlinear DAC 31 serves to compensate extra loop delay and, by its nonlinear design, in some embodiments may help to avoid instabilities at small input signals.

It should be noted in the embodiment of Fig. 3 additional feedback DAC 34 receives the output of the quantizer 33 prior to the feedback DACs, with the signal being delayed by delay element 35.

The devices of Figs. 1-3 may be manufactured by providing the various components shown and described and coupling them as shown and described. The devices of Figs. 1-3 may be used in wireless or wire-based communications systems and devices, for example provider equipment or customer premises equipment, for example in receive paths or transmit paths for wireless or wire-based communication. However, use of the devices discussed is not limited to communication systems.

Fig. 4 is a flow chart illustrating a method according to an embodiment. The method of Fig. 4 may be implemented using the devices illustrated and described with respect to Figs. 1-3, but may also be implemented independently therefrom. Moreover, while the method of Fig. 4 is shown and described as a series of acts or events, the order in which these acts or events are described is not to be construed as limiting. In particular, the acts or events may also be performed essentially parallel, for example by different circuit parts.

At 40, the method of Fig. 4 comprises performing a sigma-delta analog-to-digital conversion using a loop comprising at least one feedback digital-to-analog converter, an integrating loop filter and a quantizer. At 41, the method comprises supplying an additional feedback via a nonlinear digital-to-analog converter to the sigma-delta loop. The nonlinear digital-to-analog converter may in particular have a larger output step size around zero compared to step sizes for input signal values further away from zero, for example as explained with reference to Fig. 2.

The following examples define some non-limiting embodiments:
Example 1. An analog-to-digital converter device, comprising:
   a sigma-delta modulator loop, and
   a nonlinear digital-to-analog converter providing an additional feedback for the sigma-delta modulator loop.
Example 2. The device of example 1,
   wherein the sigma-delta modulator loop comprises:
      an analog signal input,
      an integrating loop filter, wherein a first input of the integrating loop filter is coupled to the analog signal input,
      a quantizer, wherein an input of the quantizer is coupled to an output of the integrating loop filter,
      at least one feedback digital-to-analog converter, wherein an input of the feedback digital-to-analog converter is coupled to an output of the quantizer and wherein an output of the feedback digital-to-analog converter is coupled to at least one second input of the integrating loop filter, wherein an input of the nonlinear digital-to-analog converter is coupled to the output of the quantizer and an output of the nonlinear digital-to-analog converter is coupled to an input of the quantizer.
Example 3. The device of example 2, further comprising an adder configured to subtract an output of the nonlinear digital-to-analog converter from an input to the quantizer.
Example 4. The device of example 2 or 3, further comprising a sampling switch, wherein the output of the nonlinear digital-to-analog converter is coupled to the input of the quantizer between the sampling switch and the integrating loop filter.
Example 5. The device of any one of examples 2-4, wherein the integrating loop filter comprises a multistage integrating loop filter.
Example 6. The device of any one of examples 2-5, wherein the integrating loop filter comprises one or more integrators.
Example 7. The device of any one of examples 2-6, wherein the at least one feedback digital-to-analog converter comprises at least two feedback digital-to-analog converters.
Example 8. The device of any one of examples 1-7, wherein the nonlinear digital-to-analog converter is configured to compensate excess loop delay of the sigma-delta-modulator loop.
Example 9. The device of any one of examples 1-8, wherein the nonlinear digital-to-analog converter has a larger output step size for input values around zero than for input values further away from zero.
Example 10. The device of example 9, wherein the digital converter has a first step size for an input value corresponding to one least significant bit, has a second step size for an input value following the input value of plus/minus one least significant bit, and has a third output step size for other input values, wherein the first step size is larger than the third step size and the third step size is larger than the second step size.
Example 11. The device of any one of examples 1-10, wherein the nonlinear digital-to-analog converter comprises a plurality of capacitors, wherein a subset of the plurality of capacitors comprises capacitors having a same value, wherein at least one capacitor of the plurality of capacitors has a capacitance value greater than the capacitance values of the capacitors of the subset.
Example 12. A method for analog-to-digital conversion, comprising:
   performing a sigma-delta analog-to-digital conversion using a sigma-delta loop, and
   supplying an additional feedback via a nonlinear digital-to-analog converter to the sigma-delta loop.
Example 13. The method of example 12, wherein supplying the additional feedback comprises compensating an excess loop delay.
Example 14. The method of example 12 or 13, wherein supplying the additional feedback comprises using a plurality of capacitors, wherein at least one capacitor of the plurality of capacitors has a greater capacitance value than other capacitors of the plurality of capacitors.
Example 15. The method of any one of examples 12-14, further comprising subtracting an output of the nonlinear digital-to-analog converter from an input of a quantizer of the sigma-delta loop.
Example 16. The method of example 15, further comprising coupling the output of the nonlinear digital-to-analog converter to the input of the quantizer between the quantizer and an integrating loop filter of the sigma-delta-loop.
Example 17. The method of any one of examples 12-16, wherein the nonlinear digital-to-analog converter has a larger output step size for input values around zero than for input values further away from zero.
Example 18. The method of example 17, wherein the nonlinear digital-to-analog converter has a first step size for an input value corresponding to one least significant bit, has a second step size for an input value following the input value of plus/minus one least significant bit, and has a third output step size for other input values, wherein the first step size is larger than the third step size and the third step size is larger than the second step size
Example 19. A method for providing an analog-to-digital converter device, comprising:
   providing a sigma-delta modulator loop, and
   providing a nonlinear digital-to-analog converter providing an additional feedback for the sigma-delta modulator loop.
Example 20. The method of example 19,
   wherein providing the sigma-delta modulator loop comprises:
      providing an analog signal input,
      providing an integrating loop filter,
      coupling a first input of the integrating loop filter to the analog signal input,
      providing a quantizer,
      coupling an input of the quantizer to an output of the integrating loop filter,
      providing at least one feedback digital-to-analog converter,
      coupling an input of the feedback digital-to-analog converter to an output of the quantizer and coupling an output of the feedback digital-to-analog converter to at least one second input of the integrating loop filter,
      the method further comprising coupling an input of the nonlinear digital-to-analog converter to the output of the quantizer and an output of the nonlinear digital-to-analog converter is coupled to an input of the quantizer.
Example 21. The method of example 19 or 20, further comprising providing an adder configured to subtract an output of the nonlinear digital-to-analog converter from an input to the quantizer.
Example 22. The method of any one of examples 19-21, wherein the nonlinear digital-to-analog converter has a larger output step size for input values around zero than for input values further away from zero.
Example 23. The method of example 22, wherein the nonlinear digita-to-analogl converter has a first step size for an input value corresponding to one least significant bit, has a second step size for an input value following the input value of plus/minus one least significant bit, and has a third output step size for other input values, wherein the first step size is larger than the third step size and the third step size is larger than the second step size.
Example 24. An analog-to-digital converter device, comprising:
   sigma-delta modulation means, and
   nonlinear digital-to-analog converter means providing an additional feedback for the sigma-delta modulator means.
Example 25. The device of example 24,
   wherein the sigma-delta modulator means comprises:
      an analog signal input,
      integrating loop filter means, wherein a first input of the integrating loop filter means is coupled to the analog signal input,
      quantizer means, wherein an input of the quantizer means is coupled to an output of the integrating loop filter,
      feedback digital-to-analog converter means, wherein an input of the feedback digital-to-analog converter means is coupled to an output of the quantizer means and wherein an output of the feedback digital-to-analog converter means is coupled to at least one second input of the integrating loop filter means, wherein an input of the nonlinear digital-to-analog converter means is coupled to the output of the quantizer means and an output of the nonlinear digital-to-analog converter means is coupled to an input of the quantizer means.
Example 26. The device of example 25, further comprising an adder configured to subtract an output of the nonlinear digital-to-analog converter means from an input to the quantizer means.
Example 27. The device of any one of examples 25 or 26, wherein the integrating loop filter means comprises a multistage integrating loop filter.
Example 28. The device of any one of examples 25-27, wherein the integrating loop filter means comprises one or more integrators.
Example 29. The device of any one of examples 24-28, wherein the nonlinear digital-to-analog converter means has a larger output step size for input values around zero than for input values further away from zero.
Example 30. The device of example 29, wherein the nonlinear digital-to-analog converter means has a first step size for an input value corresponding to one least significant bit, has a second step size for an input value following the input value of plus/minus one least significant bit, and has a third output step size for other input values, wherein the first step size is larger than the third step size and the third step size is larger than the second step size.

While specific implementations have been described, these are not to be construed as limiting.

## Claims

1. An analog-to-digital converter device, comprising:
a sigma-delta modulator loop, and
a nonlinear digital-to-analog converter providing an additional feedback for the sigma-delta modulator loop.

2. The device of claim 1,
wherein the sigma-delta modulator loop comprises:
an analog signal input,
an integrating loop filter, wherein a first input of the integrating loop filter is coupled to the analog signal input,
a quantizer, wherein an input of the quantizer is coupled to an output of the integrating loop filter,
at least one feedback digital-to-analog converter, wherein an input of the feedback digital-to-analog converter is coupled to an output of the quantizer and wherein an output of the feedback digital-to-analog converter is coupled to at least one second input of the integrating loop filter, wherein an input of the nonlinear digital-to-analog converter is coupled to the output of the quantizer and an output of the nonlinear digital-to-analog converter is coupled to an input of the quantizer.

3. The device of claim 2, further comprising an adder configured to subtract an output of the nonlinear digital-to-analog converter from an input to the quantizer.

4. The device of claim 2 or 3, further comprising a sampling switch, wherein the output of the nonlinear digital-to-analog converter is coupled to the input of the quantizer between the sampling switch and the integrating loop filter.

5. The device of any one of claims 2-4, wherein the integrating loop filter comprises a multistage integrating loop filter.

6. The device of any one of claims 2-5, wherein the integrating loop filter comprises one or more integrators.

7. The device of any one of claims 2-6, wherein the at least one feedback digital-to-analog converter comprises at least two feedback digital-to-analog converters.

8. The device of any one of claims 1-7, wherein the nonlinear digital-to-analog converter is configured to compensate excess loop delay of the sigma-delta-modulator loop.

9. The device of any one of claims 1-8, wherein the nonlinear digital-to-analog converter has a larger output step size for input values around zero than for input values further away from zero.

10. The device of claim 9, wherein the digital converter has a first step size for an input value corresponding to one least significant bit, has a second step size for an input value following the input value of plus/minus one least significant bit, and has a third output step size for other input values, wherein the first step size is larger than the third step size and the third step size is larger than the second step size.

11. The device of any one of claims 1-10, wherein the nonlinear digital-to-analog converter comprises a plurality of capacitors, wherein a subset of the plurality of capacitors comprises capacitors having a same value, wherein at least one capacitor of the plurality of capacitors has a capacitance value greater than the capacitance values of the capacitors of the subset.

12. A method for analog-to-digital conversion, comprising:
performing a sigma-delta analog-to-digital conversion using a sigma-delta loop, and
supplying an additional feedback via a nonlinear digital-to-analog converter to the sigma-delta loop.

13. The method of claim 12, wherein supplying the additional feedback comprises compensating an excess loop delay.

14. The method of claim 12 or 13, wherein supplying the additional feedback comprises using a plurality of capacitors, wherein at least one capacitor of the plurality of capacitors has a greater capacitance value than other capacitors of the plurality of capacitors.

15. The method of any one of claims 12-14, wherein the nonlinear digital-to-analog converter has a larger output step size for input values around zero than for input values further away from zero.
